# EUROPEAN PATENT APPLICATION

(11) **EP 4 235 772 A1**
(43) Date of publication of application: **30.08.2023**
(21) Application number: 23157443.5
(22) Date of filing: 20.02.2023
(51) Int. Cl.: H01L 23/495, H01L 23/31, H01L 23/433

(54) **SEMICONDUCTOR PACKAGE WITH OVERLAPPING LEADS AND DIE PAD**

(30) Priority: 28.02.2022 US 202263315003 P; 14.02.2023 US 202318169146
(71) Applicant: STMicroelectronics, Inc., 4027 Calamba City, Laguna (PH)
(72) Inventor: TALLEDO, Jefferson, 4027 Calamba (PH)
(74) Representative: Cabinet Beaumont

(57) **Abstract**

The present disclosure is directed to a package having a die on a die pad that has a first portion and a second portion, the second portion being larger than the first portion in a first direction. The package includes a plurality of leads, where at least a first lead has a first surface coplanar with a first, lower surface of the first portion of the die pad. The first lead having a second surface that is transverse to the first surface of the first lead. The second surface being an external surface of the lead and package. The second portion of the die pad being an extension that is overlapping the first lead.

## Description

### BACKGROUND

### Technical Field

The present disclosure is directed to semiconductor packages, in particular to semiconductor packages with overlapping leads and die pad related to printed circuit board level reliability improvement.

### Description of the Related Art

A semiconductor package consists of a semiconductor die encapsulated in a plastic protective covering to prevent any damage to the semiconductor die. In leaded semiconductor packages i.e., packages where the metallic leads or pins protrude beyond the plastic covering, the leads are bent using mechanical forming such that they can be soldered with the printed circuit boards. The life of the solder joint thus formed is a factor of the package length.

With improvements in semiconductor package functionality, larger die are being included in a smaller package footprint and this results in a higher die-to-package ratio (DPR). Higher DPR means smaller packages with larger die leading to more functionalities in a smaller area. Solder joint life, i.e., a number of cycles before failure, decreases as the DPR increases. One of the known solutions to address this problem is to increase the lead size, which causes an increase in the package size. Increases in the package size becomes inevitable as the lead size cannot be increased towards the die pad due to structural limitations. The lead size can be increased outwards away from the die, but this results in the increase in the package size.

### BRIEF SUMMARY

The present disclosure is directed to a leadframe package to improve board level reliability (BLR) and solder joint life by overlapping a die pad and plurality of leads. The package enables higher solder life even for package with a higher die-to-package ratio (DPR). This structure includes a large surface area of at least one lead on a printed circuit board (PCB) side of the package so that the large surface area can be coupled to contacts on the PCB with more solder. This larger solder connection can increase the solder life of the package.

The disclosure includes, a method of making a leadframe package that includes a high die-to-package ratio. Alternatively, smaller package size could be maintained even when the lead size is increased. A lead of the plurality of leads is formed in such a way that a lower portion of the lead is wider than an upper portion (first contact surface) of the lead. The lower portion (second contact surface) is the external or PCB facing portion of the lead. The upper portion is internal to the package, within a molding compound or encapsulant, and faces away from the PCB.

The lower portion of the lead has an extension that extends toward and under a die pad in an overlapping fashion. The die pad in this package may have a T-shape in cross-section, having an upper first portion and a lower second portion. The first portion having a horizontal extension away from the lower second portion. The horizontal extension overlapping with the extension of the lead.

The upper horizontal portion of the die pad overlaps the lower extension of the lead such that a die pad attach surface of the die pad and the first contact surface of the lead are coplanar. An external surface of the lower second portion of the die pad is coplanar with the second contact surface of the lead.

In one embodiment, the second contact surface is coupled to a contact pad on the PCB. The die pad may also be coupled to a contact pad on the PCB.

In another embodiment, the extension of the lead may be coupled to and separated from the horizontal extension of the die pad by an adhesive or mechanical coupling. The coupling is non-conductive and physically separates the extension of the lead from the horizontal extension of the die pad. There is a gap or space between the extension of the lead and the horizontal extension of the die pad that is filled with molding compound. In some embodiments, the adhesive is also in the gap, surrounded by molding compound.

In another embodiment, a dimension of an external sidewall and an internal sidewall of the lead are the same. A first contact surface of the lead is of a same size as a second contact surface of the lead. a first portion of the die pad partially overlaps the first contact surface of the lead. The die pad includes a pedestal or central lower portion that larger than the internal sidewall of the lead such that an extension of the first portion of the die pad extends away from the pedestal toward and overlapping the first contact surface of the lead. The first contact surface of the lead may be glued or attached to a lower surface of the extension of the first portion of the die pad using a non-conductive adhesive material. Alternatively, a space between the first contact surface of the lead and the extension of the first portion may be filled with molding compound alone.

### BRIEF DESCRIPTION OF THE SEVERAL VIEWS OF THE DRAWINGS

Figures 1 and 2 are cross-sectional views of a package having leads and a die pad with extensions according to the present disclosure;
Figures 3 and 4 are cross-sectional views of a package having leads and a die pad with extensions, the leads including a resin portion according to the present disclosure;
Figures 5-8 are cross-sectional views of a method of forming package with a lead frame that includes leads and a die pad with extensions according to the present disclosure; and
Figures 9-12 are cross-sectional views of different embodiments of packages having leads and a die pad with extensions that overlap according to the present disclosure.

An embodiment provides an integrated circuit package, comprising:
a plurality of leads wherein each lead of the plurality of leads has an external sidewall, an internal sidewall, a first contact surface, and a second contact surface that is opposite to the first contact surface, a first dimension of the external sidewall is greater than a second dimension of the internal sidewall;
an opening that is surrounded by the plurality of leads;
a die pad in the opening between the plurality of leads;
a semiconductor die on the die pad;
a plurality of connectors coupling the semiconductor die with a respective one of the first contact surfaces.

An embodiment provides a method, comprising:
forming a plurality of leads by removing portions of a lead frame, each lead of the plurality of leads having an external side wall with a first dimension and an extension, the extension has an internal sidewall with a second dimension that is less than the first dimension, a first contact surface, and a second contact surface that is opposite the first contact surface;
forming an opening positioned between the plurality of leads;
forming a die pad having a first portion having a die attach surface and a second portion having an external surface, the second portion being in the opening, the first portion overlapping the extensions of the plurality of leads.

According to an embodiment, the first contact surface of each lead is smaller than the second contact surface.

According to an embodiment, the second contact surface of each lead extends into the opening between the leads.

According to an embodiment, each lead includes an extension that extends past the first contact surface into the opening.

According to an embodiment, each extension extends past the first contact surface into the opening between the plurality of leads.

According to an embodiment, the die pad in the opening between the plurality of leads has a first portion and a second portion that is smaller than the first portion, the second portion being between the extensions of the plurality of leads.

According to an embodiment, the die pad includes a die attach surface that is opposite to an outer surface, the die attach surface being greater than the outer surface, the outer surface being coplanar with the second contact surfaces of the plurality of leads.

According to an embodiment, the die pad includes a first portion and a second portion, the first portion includes the die attach surface and the second portion includes the outer surface.

According to an embodiment, the internal sidewall of the each lead is spaced from the second portion of the die pad by a first distance in a first direction.

According to an embodiment, the first portion of the die pad includes extensions that extend away from the second portion towards and overlapping the leads.

According to an embodiment, the extensions of the die pad are spaced from the extensions of the leads by a second distance in a second direction that is transverse to the first direction.

An embodiment provides a package, comprising:
a die pad having a first portion and a second portion, the second portion being larger than the first portion in a first direction, the first portion having a first surface;
a first lead having a first surface coplanar with the first surface of the first portion of the die pad, the first lead having a second surface that is transverse to the first surface of the first lead, the second portion of the die pad overlapping the first lead.

According to an embodiment, the package comprises a die on the second portion of the die pad.

According to an embodiment, the package comprises an encapsulant on the first lead, the die, and the die pad, the encapsulant being between the first lead and the die pad.

According to an embodiment, a portion of the encapsulant is coplanar with the first surface of the first portion of the die pad and with the first surface of the first lead.

According to an embodiment, the encapsulant includes an external surface that is coplanar with the second surface of the first lead.

According to an embodiment, the first lead includes a first portion that is larger than a second portion in a second direction that is transverse to the first direction, the second portion of the first lead being closer to the die pad than the first portion, the second portion of the die pad overlapping the second portion of the first lead.

According to an embodiment, the package comprises a spacer between the second portion of the die pad and the second portion of the first lead.

### DETAILED DESCRIPTION

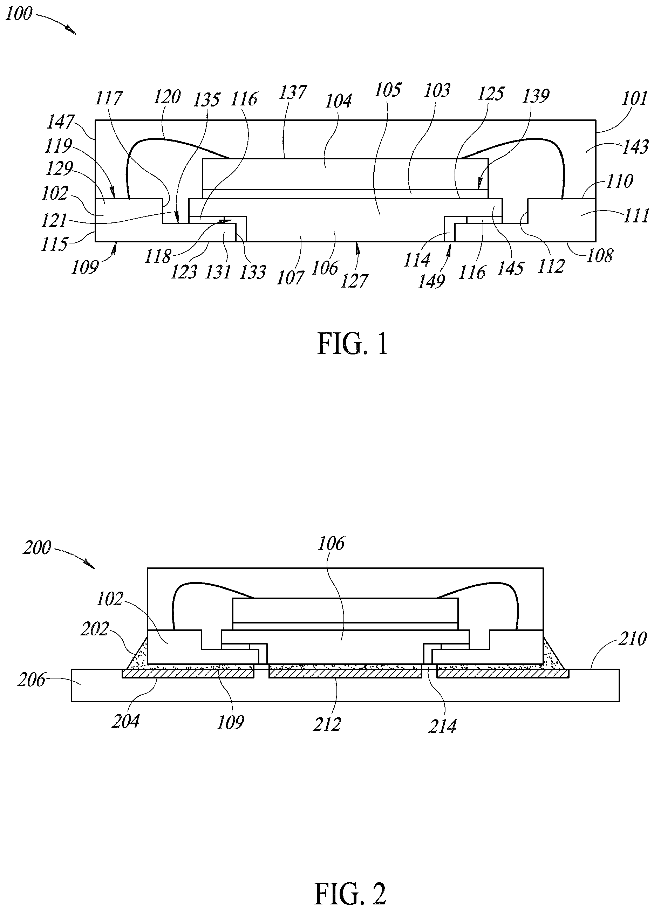

Figure 1 is an embodiment of a semiconductor package 100 with overlapping leads of a plurality of leads 110 and a die pad 106. With improvements in semiconductor package functionality, larger die are being included in a smaller package footprint and this results in higher die-to-package ratio (DPR). Higher DPR means smaller packages with larger die leading to more functionalities in a smaller area. However, solder joint life, i.e., a number of cycles before failure, decreases as the DPR increases.

The package of the present disclosure improves board level reliability (BLR) and solder joint life by overlapping a die pad and plurality of leads, allowing a contact surface of the lead to be larger. This package enables higher solder life even for package with a higher die-to-package ratio (DPR). Alternatively, smaller package size could be maintained even when the lead size is increased.

A plastic protective covering or encapsulant 101 encapsulates the elements of the semiconductor package 100. The die pad 106 is T-shaped in cross-section and includes a first portion 105 and a second portion 107. The first portion includes extensions 145 that protrude or extend away from the second portion 107. The package includes a plurality of leads that each include extensions that overlap with the extensions of the die pad.

This structure includes a large surface area of at least one lead on a printed circuit board (PCB) side of the package so that the large surface area can be coupled to contacts on the PCB. The larger surface area can couple with more solder, which increases the solder life of the package.

The die pad is separated from a die 104 by a non-conductive adhesive 103, which may be referred to as a spacer or a die pad attach. The die attach is on one side of the die. A first surface 137 of the die 104 is coupled to a first contact surface 119 of a lead 102 with a wire bond 120. A second contact surface 139 of the die 104 is coupled to the adhesive 103. The die pad 106 is also separated from the lead 102 by a space or gap 118. In some embodiments, a non-conductive adhesive 116 is in the gap 118 between the extension of the lead and the die pad.

The lead 102 of the plurality of leads 110 has an external sidewall 115 and an internal sidewall 117 that is opposite to the external sidewall. A first dimension of the external sidewall 115 is greater than a second dimension of the internal sidewall 117. The first contact surface 119 is transverse to the external and internal sidewalls. A second contact surface 109 is opposite to the first contact surface. The first contact surface 119 of each lead 102 is smaller than the second contact surface 109.

The second contact surface 109 of each lead 102 extends into an opening 121 between the plurality of leads 110. Each lead 102 of the plurality of leads 110 has an extension 123 that extends past the first contact surface 119 and internal sidewall 117 into the opening 121. The die pad 106 in the opening 121 between the plurality of leads has the first portion 105 and the second portion 107 that is smaller than the first portion 105. The second portion 107 being between the extensions 123 of the plurality of leads. The die pad 106 includes a die attach surface 125 that is opposite to an outer or external surface 127. The die attach surface 125 is greater than the outer surface 127, the outer surface 127 being coplanar with the second contact surfaces 109 of the plurality of leads. The die pad and the plurality of leads are two parts of a lead frame of this package.

The first portion 105 of the die pad 106 includes the die attach surface 125 and the second portion 107 includes the outer surface 127. The lead 102 includes a first portion 129 which is narrower than a second portion 131 as measured from the surface 109 toward the encapsulant in Figure 1. The first portion includes the first contact surface 119 and the second portion includes the second, larger contact surface 109 that is opposite to the first contact surface 119. The lead includes the external sidewall 115, the first internal sidewall 117 and a second internal sidewall 133. The first and second internal sidewalls 117, 133 together are a same dimension of the external sidewall. A third contact surface 135 is between the first contact surface 119 and the second contact surface 109 and between the first internal sidewall 117 and the second internal sidewall 133.

The die pad 106 has the first extension portion 105 and the second central or base portion 107. The first extension portion 105 overlaps the third contact surface 135 of the lead 102. The package has openings or gaps 118, 114 that are between the extensions of the leads 102 and the extensions 145 of the die pad 106. These openings 118, 114 are filed with encapsulant or molding compound when the other components are encased in the encapsulant or molding compound. The molding compound is formed in a mold that forms sidewalls 147 that are coplanar with the external sidewall 115 of the lead. The molding compound forms the top and sides of the package. A small portion 149 of molding compound is exposed on the bottom surface of the package between the leads 102 and the die pad 106.

Figure 2 is an embodiment of a semiconductor package 200 coupled to a Printed Circuit Board (PCB) 206 with a coupling material 202, such as solder or other conductive paste. The package 200 includes the die 104 and the lead frame having the leads 102 and the die pad 106 of Figure 1. The PCB 206 includes contact pads 204 formed on or in the PCB surface 210. The second contact surface 109 of the lead 102 is coupled to the contact pad 204. The PCB pad 204 is physically coupled to or embedded within the PCB 206.

The coupling material 202 is in contact with the external sidewall 115 and the second contact surface 109 of the lead 102. In some embodiments, there is a contact pad 212 in the PCB 206 that is coupled to the portion 107 of the die pad. Openings 214 may exist between the coupling material 202 attached to one of the leads and the coupling material attached to the die pad. The opening 214 may be air or other dielectric. The opening is aligned with the small portion 149 of molding compound on the bottom or back surface of the package.

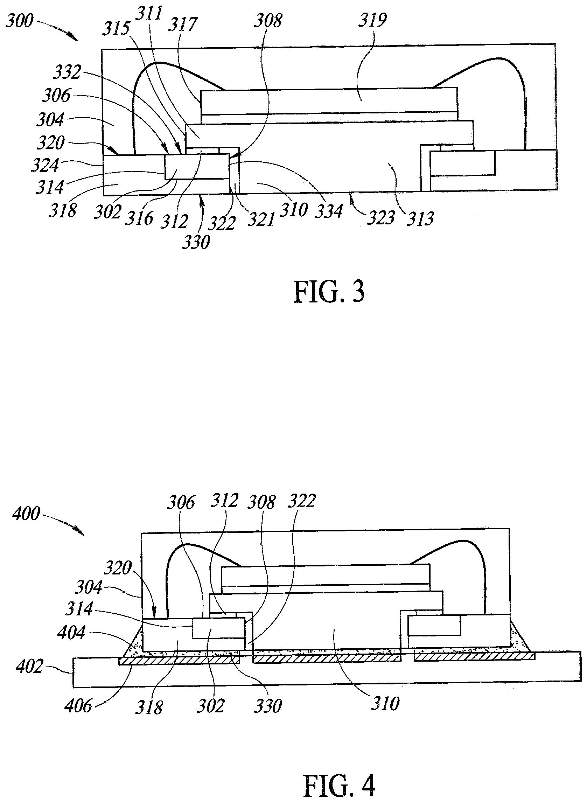

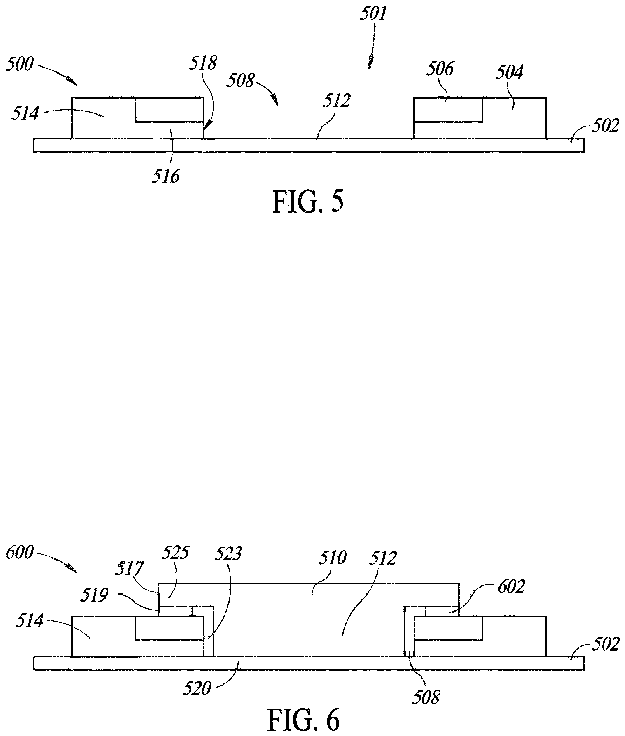

Figures 3 and 4 are alternative embodiments of a semiconductor package 300 with a pre-molded lead-frame 304. Figure 5, 6, and 7, are a method of forming the package 300 of Figures 3 and 4. A lead 318 has an external sidewall 324 and two internal sidewalls 314 and 322 that are opposite to the external sidewall. The two internal sidewalls 314 and 322 can be of the same or different dimensions. A first dimension of the external sidewall 324 is greater than a second dimension of the internal sidewall 314. The first dimension of the external sidewall is also greater than a third dimension of the internal sidewall 322.

A first contact surface 320 of the lead 318 is transverse to the external and internal sidewalls. A second contact surface 330 is opposite to the first contact surface. The first contact surface 320 of each lead 318 is smaller than the second contact surface 330.

The lead frame includes a resin or other dielectric 302, which provides a structural strength to each lead of the pre-molded lead frame 304. A fourth dimension of a first surface 332 of the resin 302 is the same as a fifth dimension of an internal sidewall 316 of the lead 318. A sixth dimension of a sidewall 334 of the resin 302 is of the same size as the second dimension of the internal sidewall 314 of the lead 318.

The die pad 310 includes an extension 311 that extends from a central support or base 313. The extension 311 may extend away from the base in all directions or may only extend past the base in two directions. The extension has an outermost sidewall 315 that overlaps the resin 302 of the lead 318. An edge 317 of a die 319 also overlaps the resin 302. The edge 317 is further from the external sidewall 324 of the lead than the outermost sidewall 315 of the extension 311.

The die pad 310 is separated from the resin 302 by a space 321. In some embodiments, a non-conductive or dielectric adhesive or support 312 is in the space and physically separates the extension 311 from the resin 302. A surface 306 formed by the first surface 332 of the resin 302 is coplanar with a first contact surface 320 of the lead 318. A surface 308 of the resin 302 is coplanar with the second internal sidewall 322 of the lead 318. A sum of the sixth dimension of the resin 302 and the second dimension of the internal sidewall of the lead 318 is equal to the first dimension of the external sidewall 324 (i.e. the external height) of the lead 318.

In some embodiments, the space 321 includes a first portion between the lead and the base 313 and a second portion between the resin and the extension 311. In some embodiments the first portion has a substantially similar dimension to the second portion. In alternative embodiments, the first portion has a larger dimension between the lead and the die pad than the second portion. As in Figure 1, the second contact surface 330 of the lead is coplanar with an external surface 323 of the base 313.

Figure 4 is the package 300 of Figure 3 coupled a Printed Circuit Board (PCB) 402 with a coupling material 404 through a PCB pad 406. The second contact surface 330 of the lead 318 is coupled to the PCB pad 406. The PCB pad 406 is physically coupled to the PCB 402 with a conductive paste 404. The package with PCB 400 includes the resin 302 in the lead to provide structural support to the lead frame 304. The die pad 310 is separated from the resin 302 by the non-conductive adhesive 312.

Figure 5 is a method of making the semiconductor package 300 of Figure 3. The process begins at step 500 with a pre-molded lead frame 501 on a carrier 502. The lead frame 501 includes a pre-molded resin 506 embedded or otherwise integrated with a lead 504. The lead frame is etched; forming a cavity 508 sized and shaped to receive a die pad in a next step of the method of making the semiconductor package 500. The leads are also etched to form the step or tiered aspect of the lead onto which the resin or dielectric 506 is formed. The etching of the lead forms an exterior portion 514 and an interior extension 516.

The extension 516 creates a larger surface area that is coupled to the carrier 502 as compared to a surface area of the exterior portion 514 of the lead that is facing away from the carrier. An interior surface 518 of each lead faces other interior surfaces of adjacent leads at boundaries of the opening 508.

Figure 6 is a next step 600 in the method of making the semiconductor package 300 that includes placing a die pad 510 in the opening 508 between the leads. A surface 520 of the die pad is coplanar with the larger surfaces (facing the carrier) of the leads 504. A space 523, which is a remaining portion of the opening 508 is between the die pad 510 and the lead 504.

In some embodiments, a spacer or non-conductive adhesive 602 is attached to the resin and the die pad, with extension 525 placed on the resin 506. Alternatively, the spacer 602 may be placed on the extension before the die pad 510 is placed between the leads. An edge 519 of the spacer may be coplanar with an edge 517 of the extension 525. The edge 519 may be closer to a central base 521 of the die pad than the edge 517 of the extension.

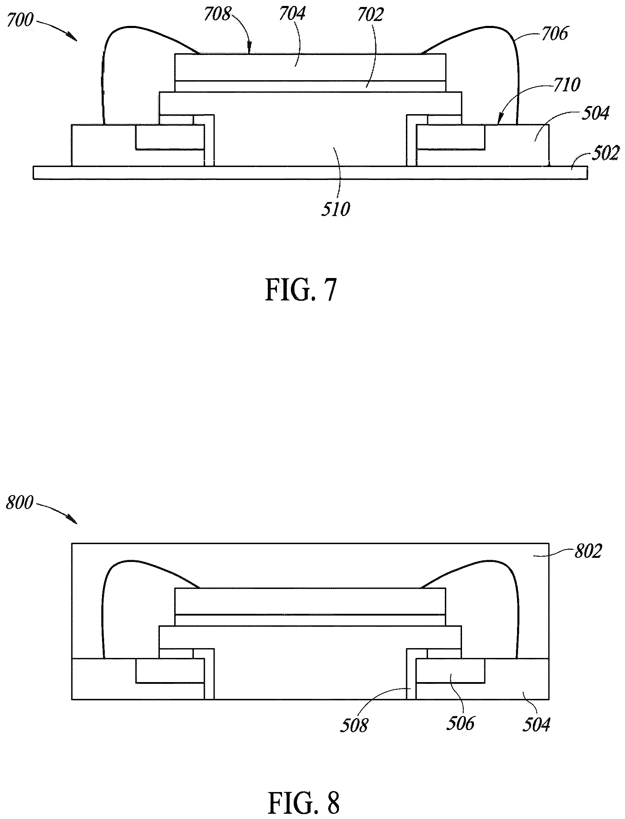

Figure 7 is a next step 700 in the method of making the semiconductor package 300. The method includes coupling a die 704 to the die pad 510 using a non-conductive adhesive material or a die pad attach 702. The method includes electrically coupling the die 704 with the lead 504 using a wire bond 706. The wire bond is coupled between the die 704 on the surface 708 of the die and the surface 710 of the lead 504.

Figure 8 is a next step 800 in the method of making the semiconductor package 300. The method includes encapsulating the wire bonded lead frame using an encapsulating material 802, filling all the empty spaces with the encapsulating material. This includes filling the space 523 between the die pad and the leads with encapsulating material. Once the encapsulating material is hardened or otherwise cured, the carrier is removed.

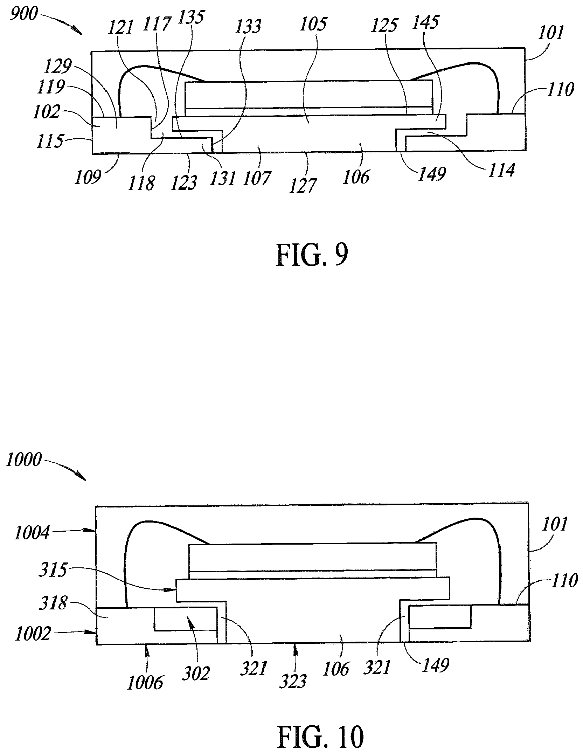

Figure 9 is an alternative embodiment of a semiconductor package 900 that is substantially similar to the package 100 of Figure 1, however the package 900 does not include the spacer 116. Similar reference numbers will be reused to simplify the description. The space 118 between the lead 102 and the die pad 106 is filled with the molding compound 101. The molding compound 101 provides strength to the lead frame in the absence of the spacer 116.

The plastic protective covering or encapsulant 101 encapsulates the elements of the semiconductor package 900. The die pad 106 is T-shaped in cross-section and includes the first portion 105 that is wider than the second portion 107. The first portion includes extensions 145 that protrude or extend away from the second portion 107. The package includes the plurality of leads 110 that each include extensions toward the second portion 107 that overlap with the extensions 145 of the die pad. The extensions 145 of the die pad is spaced from the extension 123 of the lead 102 by the space 118. The molding compound 101 moves into the space 118 and fills the space between the extensions 145 and 123. A portion 149 of the molding compound in the space 118 is coplanar with the outer surface 127 of the die pad 106 and with the outer surface 109 of the lead 102.

The lead 102 of the plurality of leads 110 has an external sidewall 115 and an internal sidewall 117 that is opposite to the external sidewall. A first dimension of the external sidewall 115 is greater than a second dimension of the internal sidewall 117. The molding compound 101 is in contact with the internal sidewall 117. The first contact surface 119 is transverse to the external and internal sidewalls. A second contact surface 109 is opposite to the first contact surface. The first contact surface 119 of each lead 102 is smaller than the second contact surface 109. This larger surface 109 provides a larger contact area for coupling the package 900 to a printed circuit board or other electronic system.

The second contact surface 109 of each lead 102 extends into an opening 121 between the plurality of leads 110. Each lead 102 of the plurality of leads 110 has an extension 123 that extends past the first contact surface 119 and internal sidewall 117 into the opening 121. The die pad 106 in the opening 121 between the plurality of leads has the first portion 105 and the second portion 107 that is smaller than the first portion 105. This difference in size creates the space 118 that is filled with molding compound 101 that includes a first portion between the extension 145 and the internal sidewall 117. This first portion includes a first dimension between the internal sidewall 117 and the extension 145. There is a second portion between the extension 145 and the third contact surface 135 of the extension 123 of the lead 102. The second portion has a second dimension between the extension 145 and the third contact surface. The second dimension is less than the first dimension in some embodiments. There is a third portion between the second portion 107 of the die pad 106 and the extension 123, which corresponds to the internal sidewall 133. The third portion has a third dimension between the second portion 107 and the internal sidewall 133. The third dimension is a different than the second dimension. The third dimension is less than the first dimension.

The second portion 107 being between the extensions 123 of the plurality of leads. The die pad 106 includes a die attach surface 125 that is opposite to an outer or external surface 127. The die attach surface 125 is greater than the outer surface 127, the outer surface 127 being coplanar with the second contact surfaces 109 of the plurality of leads. The die pad and the plurality of leads are two parts of a lead frame of this package.

The first portion 105 of the die pad 106 includes the die attach surface 125 and the second portion 107 includes the outer surface 127. The lead 102 includes a first portion 129 which is narrower than a second portion 131. The first portion includes the first contact surface 119 and the second portion includes the second, larger contact surface 109 that is opposite to the first contact surface 119. The lead includes the external sidewall 115, the first internal sidewall 117 and a second internal sidewall 133. The first and second internal sidewalls 117, 133 together are a same dimension of the external sidewall. A third contact surface 135 is between the first contact surface 119 and the second contact surface 109 and between the first internal sidewall 117 and the second internal sidewall 133. The molding compound between these extensions provides support and electrical isolation.

The die pad 106 has the first extension portion 105 and the second central or base portion 107. The first extension portion 105 overlaps the third contact surface 135 of the lead 102. The package has openings or gaps 118, 114 that are between the extensions 123 of the leads 102 and the extensions 145 of the die pad 106. These openings 118, 114 are filed with encapsulant or molding compound when the other components are encased in the encapsulant or molding compound. The molding compound is formed in a mold that forms sidewalls 147 that are coplanar with the external sidewall 115 of the lead. The molding compound forms the top and sides of the package. A small portion 149 of molding compound is exposed on the bottom surface of the package between the leads 102 and the die pad 106.

Figure 10 is an alternative embodiment of semiconductor package 1000, which is similar to the package 300 of Figure 3 without the spacer 312. The space 321 between the lead 102 and the die pad 106 are filled with a molding compound 101. The molding compound 101 provides strength to the lead frame in the absence of the spacer 116. A small portion 149 of molding compound is exposed on the bottom surface of the package between the leads 102 and the die pad 106.

In this embodiment, each lead 318 has a side external surface 1002 that is coplanar with a side external surface 1004 of the molding compound. A lower external surface 1006 is transverse to the side external surface 1002. The lower external surface 1006 is coplanar with a surface of the portion 149 and with the surface 323 of the die pad 106. The lead 318 includes a resin or non-conductive portion 302. The extension 311 of the die pad 106 extends over the resin 302. In the illustrated embodiment, an end or outermost sidewall 315 is positioned with boundaries of the resin and is spaced from the resin by molding compound that fills in the space 321.

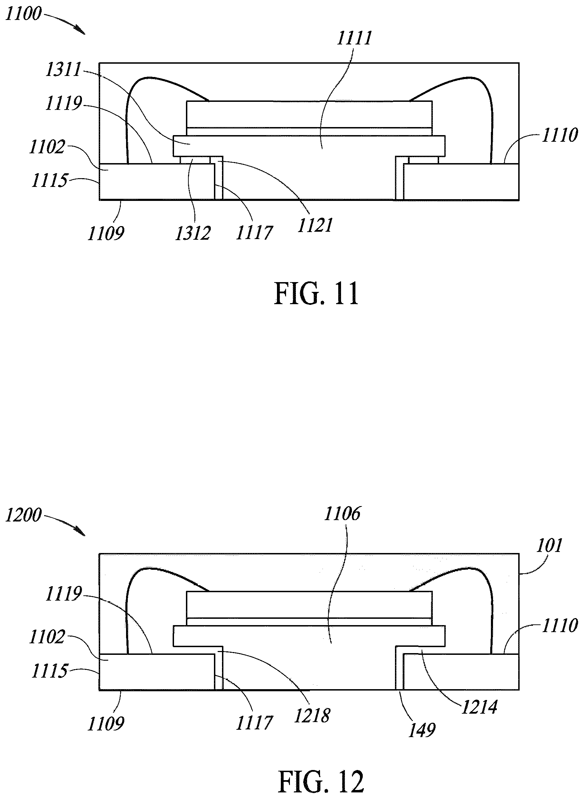

Figure 11 is an alternative embodiment of semiconductor package 1100 without the resin or dielectric 302 in the lead. The lead 1102 of the plurality of leads 1110 has an external sidewall 1115 and an internal sidewall 1117 that is opposite to the external sidewall. A first dimension of the external sidewall 1115 is substantially the same as the second dimension of the internal sidewall 1117. The first contact surface 1119 is transverse to the external and internal sidewalls. A second contact surface 1109 is opposite to the first contact surface. The first contact surface 1119 of each lead 1102 is of the same size as the second contact surface 1109.

The die pad 1111 is separated from the lead 1102 by a space 1121. In this embodiment, a non-conductive or dielectric adhesive or support or spacer 1112 is in the space and physically separates the extension 1311 of the die pad 1111 from the lead 1102. The spacer 1312 is coupled to the lead 1102 on its surface 1119 on one side and to the extension 1311 on the other side. The lead 1102 is rectangular in cross-section and is a consistent material from sidewall to sidewall 1115, 1117.

Figure 12 is an alternative embodiment of semiconductor package 1100 without the spacer 312. The lead 1102 of the plurality of leads 1110 has an external sidewall 1115 and an internal sidewall 1117 that is opposite to the external sidewall. A first dimension of the external sidewall 1115 is same as the second dimension of the internal sidewall 1117. The first contact surface 1119 is transverse to the external and internal sidewalls. A second contact surface 1109 is opposite to the first contact surface. The first contact surface 1119 of each lead 1102 is of the same size as the second contact surface 1109.

The spaces 1218 and 1214 between the lead 1102 and the die pad 1106 are filled with a molding compound 101. The molding compound 101 provides strength to the lead frame in the absence of the spacer 312. A small portion 149 of molding compound is exposed on the bottom surface of the package between the leads 1102 and the die pad 1106.

An embodiment of the present disclosure is directed to an integrated circuit package that includes a plurality of leads wherein each lead of the plurality of leads has an external sidewall, an internal sidewall, a first contact surface, and a second contact surface that is opposite to the first contact surface, a first dimension of the external sidewall is greater than a second dimension of the internal sidewall. The package includes an opening that is surrounded by the plurality of leads and a die pad in the opening between the plurality of leads. A semiconductor die is on the die pad. A plurality of connectors coupling the semiconductor die with a respective one of the first contact surfaces. The integrated circuit package has the first contact surface of each lead that is smaller than the second contact surface. The second contact surface of each lead extends into the opening between the leads. Each lead includes an extension that extends past the first contact surface into the opening. The die pad in the opening between the plurality of leads has a first portion and a second portion that is smaller than the first portion, the second portion being between the extensions of the plurality of leads.

The die pad includes a die attach surface that is opposite to an outer surface, the die attach surface being greater than the outer surface, the outer surface being coplanar with the second contact surfaces of the plurality of leads. The die pad includes a first portion and a second portion, the first portion includes the die attach surface and the second portion includes the outer surface.

The internal sidewall of the each lead is spaced from the second portion of the die pad by a first distance in a first direction. The first portion of the die pad includes extensions that extend away from the second portion towards and overlapping the leads. The extensions of the die pad are spaced from the extensions of the leads by a second distance in a second direction that is transverse to the first direction.

The present disclosure is also directed to a method that includes forming a plurality of leads by removing portions of a lead frame, each lead of the plurality of leads having an external sidewall with a first dimension and an extension, the extension has an internal sidewall with a second dimension that is less than the first dimension, a first contact surface, and a second contact surface that is opposite the first contact surface; forming an opening positioned between the plurality of leads; forming a die pad having a first portion having a die attach surface and a second portion having an external surface, the second portion being in the opening, the first portion overlapping the extensions of the plurality of leads. The method including forming the plurality of leads includes forming the first contact surface of each lead to be smaller than the second contact surface. The method including forming the plurality of leads includes forming each extension to extend past the first contact surface into the opening between the plurality of leads.

Another embodiment includes a method of forming a package by attaching a semiconductor die on a die pad that is in an opening between a plurality of leads, each lead including a first portion with a first contact surface, and a second portion with a second contact surface that is opposite to and larger than the first contact surface, each lead including an extension from the first contact surface into the opening; coupling a plurality of connectors from the semiconductor die to a first contact surface of leads of the plurality of leads; and encapsulating the plurality of leads, the die pad, the semiconductor die, each lead including encapsulant between the first portion of the lead and the die pad and between the second portion of the lead and the die pad. The encapsulating includes forming the encapsulate between the die pad that has a first portion that is larger than a second portion, the second portion being in the opening between the plurality of leads.

The present disclosure is directed to a package that includes a die pad having a first portion and a second portion, the second portion being larger than the first portion in a first direction, the first portion having a first surface and a first lead having a first surface coplanar with the first surface of the first portion of the die pad, the first lead having a second surface that is transverse to the first surface of the first lead, the second portion of the die pad overlapping the first lead.

The package includes a die on the second portion of the die pad. The package includes an encapsulant on the first lead, the die, and the die pad, the encapsulant being between the first lead and the die pad. The package includes a portion of the encapsulant is coplanar with the first surface of the first portion of the die pad and with the first surface of the first lead. The encapsulant includes an external surface that is coplanar with the second surface of the first lead. The first lead includes a first portion that is larger than a second portion in a second direction that is transverse to the first direction, the second portion of the first lead being closer to the die pad than the first portion, the second portion of the die pad overlapping the second portion of the first lead. A spacer is between the second portion of the die pad and the second portion of the first lead.

Example embodiments of the invention are summarized here. Other embodiments can also be understood from the entirety of the specification as well as the claims filed herein.

Example 1. An integrated circuit package, comprising:
a plurality of leads wherein each lead of the plurality of leads has an external sidewall, an internal sidewall, a first contact surface, and a second contact surface that is opposite to the first contact surface, a first dimension of the external sidewall is greater than a second dimension of the internal sidewall;
an opening that is surrounded by the plurality of leads;
a die pad in the opening between the plurality of leads;
a semiconductor die on the die pad;
a plurality of connectors coupling the semiconductor die with a respective one of the first contact surfaces.

Example 2. The integrated circuit package of example 1 wherein the first contact surface of each lead is smaller than the second contact surface.

Example 3. The integrated circuit package of example 2 wherein the second contact surface of each lead extends into the opening between the leads.

Example 4. The integrated circuit package of any of examples 1 to 3 wherein each lead includes an extension that extends past the first contact surface into the opening.

Example 5. The integrated circuit package of any of example 1 to 4 wherein the die pad in the opening between the plurality of leads has a first portion and a second portion that is smaller than the first portion, the second portion being between the extensions of the plurality of leads.

Example 6. The integrated circuit package of any of examples 1 to 5 wherein the die pad includes a die attach surface that is opposite to an outer surface, the die attach surface being greater than the outer surface, the outer surface being coplanar with the second contact surfaces of the plurality of leads.

Example 7. The integrated circuit package of any of examples 1 to 6, wherein the die pad includes a first portion and a second portion, the first portion includes the die attach surface and the second portion includes the outer surface.

Example 8. The integrated circuit package of example 7 wherein the internal sidewall of the each lead is spaced from the second portion of the die pad by a first distance in a first direction.

Example 9. The integrated circuit package of example 7 or 8 wherein the first portion of the die pad includes extensions that extend away from the second portion towards and overlapping the leads.

Example 10. The integrated circuit package of any of examples 7 to 9 wherein the extensions of the die pad are spaced from the extensions of the leads by a second distance in a second direction that is transverse to the first direction.

Example 11. A method, comprising:
forming a plurality of leads by removing portions of a lead frame, each lead of the plurality of leads having an external side wall with a first dimension and an extension, the extension has an internal sidewall with a second dimension that is less than the first dimension, a first contact surface, and a second contact surface that is opposite the first contact surface;
forming an opening positioned between the plurality of leads;
forming a die pad having a first portion having a die attach surface and a second portion having an external surface, the second portion being in the opening, the first portion overlapping the extensions of the plurality of leads.

Example 12. The method of example 11 wherein forming the plurality of leads includes forming the first contact surface of each lead to be smaller than the second contact surface.

Example 13. The method of example 11 or 12 wherein forming the plurality of leads includes forming each extension to extend past the first contact surface into the opening between the plurality of leads.

Example 14. A package, comprising:
a die pad having a first portion and a second portion, the second portion being larger than the first portion in a first direction, the first portion having a first surface;
a first lead having a first surface coplanar with the first surface of the first portion of the die pad, the first lead having a second surface that is transverse to the first surface of the first lead, the second portion of the die pad overlapping the first lead.

Example 15. The package of example 14, comprising a die on the second portion of the die pad.

Example 16. The package of example 15, comprising an encapsulant on the first lead, the die, and the die pad, the encapsulant being between the first lead and the die pad.

Example 17. The package of example 16 wherein a portion of the encapsulant is coplanar with the first surface of the first portion of the die pad and with the first surface of the first lead.

Example 18. The package of example 16 or 17 wherein the encapsulant includes an external surface that is coplanar with the second surface of the first lead.

Example 19. The package of any of examples 14 to 18 wherein the first lead includes a first portion that is larger than a second portion in a second direction that is transverse to the first direction, the second portion of the first lead being closer to the die pad than the first portion, the second portion of the die pad overlapping the second portion of the first lead.

Example 20. The package of example 19, comprising a spacer between the second portion of the die pad and the second portion of the first lead.

The various embodiments described above can be combined to provide further embodiments. All of the U.S. patents, U.S. patent application publications, U.S. patent applications, foreign patents, foreign patent applications and non-patent publications referred to in this specification and/or listed in the Application Data Sheet are incorporated herein by reference, in their entirety. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. An integrated circuit package, comprising:
a plurality of leads wherein each lead of the plurality of leads has an external sidewall, an internal sidewall, a first contact surface, and a second contact surface that is opposite to the first contact surface, a first dimension of the external sidewall is greater than a second dimension of the internal sidewall;
an opening that is surrounded by the plurality of leads;
a die pad in the opening between the plurality of leads;
a semiconductor die on the die pad;
a plurality of connectors coupling the semiconductor die with a respective one of the first contact surfaces.

2. A method, comprising:
forming a plurality of leads by removing portions of a lead frame, each lead of the plurality of leads having an external side wall with a first dimension and an extension, the extension has an internal sidewall with a second dimension that is less than the first dimension, a first contact surface, and a second contact surface that is opposite the first contact surface;
forming an opening positioned between the plurality of leads;
forming a die pad having a first portion having a die attach surface and a second portion having an external surface, the second portion being in the opening, the first portion overlapping the extensions of the plurality of leads.

3. The integrated circuit package of claim 1, or the method of claim 2, wherein the first contact surface of each lead is smaller than the second contact surface.

4. The integrated circuit package of claim 2, or the method of claim 3, wherein the second contact surface of each lead extends into the opening between the leads.

5. The integrated circuit package of any of claims 1, 3 and 4, or the method of any of claims 2 to 4, wherein each lead includes an extension that extends past the first contact surface into the opening.

6. The integrated circuit or the method of claim 5, wherein each extension extends past the first contact surface into the opening between the plurality of leads.

7. The integrated circuit package of any of claims 1, 3 to 6, or the method of any of claims 2 to 6, wherein the die pad in the opening between the plurality of leads has a first portion and a second portion that is smaller than the first portion, the second portion being between the extensions of the plurality of leads.

8. The integrated circuit package of any of claims 1, 3 to 7, or the method of any of claims 2 to 7 wherein the die pad includes a die attach surface that is opposite to an outer surface, the die attach surface being greater than the outer surface, the outer surface being coplanar with the second contact surfaces of the plurality of leads.

9. The integrated circuit package of any of claims 1, 3 to 8, or the method of any of claims 2 to 8, wherein the die pad includes a first portion and a second portion, the first portion includes the die attach surface and the second portion includes the outer surface.

10. The integrated circuit package or the method of claim 9, wherein the internal sidewall of the each lead is spaced from the second portion of the die pad by a first distance in a first direction.

11. The integrated circuit package or the method of claim 9 or 10, wherein the first portion of the die pad includes extensions that extend away from the second portion towards and overlapping the leads.

12. The integrated circuit package or the method of any of claims 9 to 11, wherein the extensions of the die pad are spaced from the extensions of the leads by a second distance in a second direction that is transverse to the first direction.

13. A package, comprising:
a die pad having a first portion and a second portion, the second portion being larger than the first portion in a first direction, the first portion having a first surface;
a first lead having a first surface coplanar with the first surface of the first portion of the die pad, the first lead having a second surface that is transverse to the first surface of the first lead, the second portion of the die pad overlapping the first lead.

14. The package of claim 13, comprising a die on the second portion of the die pad.

15. The package of claim 14, comprising an encapsulant on the first lead, the die, and the die pad, the encapsulant being between the first lead and the die pad.

16. The package of claim 15, wherein a portion of the encapsulant is coplanar with the first surface of the first portion of the die pad and with the first surface of the first lead.

17. The package of claim 14 or 15, wherein the encapsulant includes an external surface that is coplanar with the second surface of the first lead.

18. The package of any of claims 14 to 17, wherein the first lead includes a first portion that is larger than a second portion in a second direction that is transverse to the first direction, the second portion of the first lead being closer to the die pad than the first portion, the second portion of the die pad overlapping the second portion of the first lead.

19. The package of claim 18, comprising a spacer between the second portion of the die pad and the second portion of the first lead.
